# EUROPÄISCHE PATENTSCHRIFT

(11) **EP 3 948 943 B1**
(45) Veröffentlichungstag und Bekanntmachung des Hinweises auf die Patenterteilung: **12.02.2025**
(21) Anmeldenummer: 20800064.6
(22) Anmeldetag: 27.10.2020
(51) Int. Cl.: H03K 17/72, H01L 23/00, H01L 25/11, H01L 25/07

(54) **SCHALTELEMENT**
SWITCHING ELEMENT
ÉLÉMENT DE COMMUTATION

(30) Priorität: 15.04.2020 DE 102020002283
(43) Veröffentlichungstag der Anmeldung: 09.02.2022
(73) Patentinhaber: Marquardt GmbH, 78604 Rietheim-Weilheim (DE)
(72) Erfinder: HAGGE, Torsten, 24943 Flensburg (DE); PENISCH, Johannes, 24943 Flensburg (DE)
(74) Vertreter: Staeger & Sperling Partnerschaftsgesellschaft mbB
(86) Internationale Anmeldenummer: PCT/EP2020/080174
(87) Internationale Veröffentlichungsnummer: WO 2021/209164

(56) Entgegenhaltungen:
- DE-A1- 102017 006 159
- US-A1- 2009 103 342

## Beschreibung

Die Erfindung geht aus von einem Schaltelement nach dem Oberbegriff des Patentanspruchs 1.

Ein derartiges Schaltelement kann zur Herstellung einer Kurzschlussverbindung, beispielsweise in der Elektromobilität, verwendet werden. Insbesondere bei Fahrzeugen mit einer Brennstoffzelle kann das Schaltelement zum sicheren Kurzschließen in der Brennstoffzelle, beispielsweise zu Servicezwecken für das Fahrzeug in der Werkstatt, bei einem geparkten Fahrzeug, bei einem verunfallten Fahrzeug o. dgl., dienen.

Ein solches Schaltelement weist zwei voneinander beabstandet angeordnete Stromschienen auf. Zwischen den beiden Stromschienen ist wenigsten ein, jeweils an den Stromschienen anliegender Leistungshalbleiter angeordnet. Der Leistungshalbleiter ist zwischen einem elektrisch nichtleitenden und einem elektrisch leitenden Zustand umschaltbar. In nichtleitenden Zustand sind die beiden Stromschienen voneinander elektrisch getrennt. Im leitenden Zustand ist hingegen ein elektrischer Kurzschluss zwischen den beiden Stromschienen hergestellt. Die bisher hierfür verwendeten gehäusten Leistungshalbleiter sind mittels einer Pressverbindung an den Stromschienen zur elektrischen Verbindung angebracht. Es hat sich herausgestellt, dass die elektrische Verbindung nicht zuverlässig ist. Außerdem sind die gehäusten Halbleiter teuer.

Ein ähnliches Schaltelement ist beispielsweise aus dem Dokument US 2009/103342 A1 bekannt.

Der Erfindung liegt die Aufgabe zugrunde, das Schaltelement derart weiterzuentwickeln, dass dessen Betriebs- und/oder Funktionssicherheit verbessert ist. Insbesondere soll auch das Schaltelement kostengünstiger sein.

Diese Aufgabe wird bei einem gattungsgemäßen Schaltelement durch die kennzeichnenden Merkmale des Anspruchs 1 gelöst.

Beim erfindungsgemäßen Schaltelement, welches durch die Merkmale des Anspruchs 1 definiert ist, ist ein Mittel zur Anpressung des Leistungshalbleiters an die Stromschienen vorgesehen. Aufgrund der Anpressung ist eine sichere elektrische Kontaktierung des Leistungshalbleiters an den Stromschienen geschaffen, so dass das Schaltelement in zuverlässiger Weise betreibbar ist. Weitere Ausgestaltungen der Erfindung sind Gegenstand der Unteransprüche.

In einfacher Art und Weise umfasst das Mittel zur Anpressung des Leistungshalbleiters an die Stromschienen eine auf die eine Stromschiene einwirkende Feder. Die Feder kann insbesondere als ein Federpaket bestehend aus Tellerfedern ausgebildet sein, so dass eine hohe Kontaktkraft an den Stromschienen sichergestellt ist. Des Weiteren umfasst das Mittel zur Anpressung des Leistungshalbleiters an die Stromschienen einen auf die andere Stromschiene einwirkenden Keil, so dass die Kontaktkraft auf einfache Art einstellbar ist.

Zur Schaltung von hohen Strömen können zwei Leistungshalbleiter parallel zwischen den Stromschienen angeordnet sein. In kostengünstiger Weise kann es sich bei dem Leistungshalbleiter um einen Leistungstransistor, insbesondere um einen Thyristor, handeln. Des Weiteren kann der Leistungshalbleiter in Form eines scheibenförmigen, ungehäusten Pellets ausgebildet sein. Solche Leistungshalbleiter-Scheiben, auch als Bauform PUK bezeichnet, sind weitaus kostengünstiger als ein in ein Gehäuse verpresster Leistungshalbleiter.

In weiterer Ausgestaltung kann der Leistungshalbleiter einen Steueranschluss in der Art eines Gates zum Umschalten zwischen dem nichtleitenden und dem leitenden Zustand aufweisen. Des Weiteren kann eine Steuerschaltung zur Ansteuerung des Leistungshalbleiters vorgesehen sein. Zweckmäßigerweise kann eine Kontaktfeder zur zuverlässigen elektrischen Verbindung zwischen dem Steueranschluss des Leistungshalbleiters und der Steuerschaltung vorgesehen sein, beispielsweise um die Stromzündung des Thyristors zu ermöglichen.

In kompakter Anordnung kann die Steuerschaltung auf einer Leiterplatte befindlich sein. Der Steueranschluss für den Leistungshalbleiter kann in einer Vertiefung an der Oberfläche des Pellets befindlich sein. Zweckmäßigerweise kann die Kontaktfeder einerseits am Steueranschluss des Leistungshalbleiters, und zwar insbesondere in der Vertiefung, gehalten sein sowie andererseits mit der Steuerschaltung in elektrischer Verbindung stehen. Beispielsweise kann die Kontaktfeder an einer auf der Leiterplatte befindlichen Kontaktfläche anliegen, wobei die Kontaktfläche wiederum die elektrische Verbindung zur Steuerschaltung herstellt.

Zwecks einfacher Montage kann eine Aufnahme für die Feder vorgesehen sein. Die Aufnahme kann an der einen Stromschiene anliegen. Des Weiteren kann der Aufnahme gegenüberliegend eine Druckplatte zur Abstützung der Feder vorgesehen sein. Schließlich kann eine Stützplatte für die Halterung des Leistungshalbleiters sowie gegebenenfalls der beiden Stromschienen vorgesehen sein. Der einfachen Montage halber können die Aufnahme, die Druckplatte und die Stützplatte in der Art einer Vorbaugruppe ausgebildet sein, wobei die Feder, die Stromschienen sowie der Leistungshalbleiter in der Vorbaugruppe aufgenommen sind.

Für das Schaltelement kann ein Gehäuse vorgesehen sein. Zweckmäßigerweise kann das Gehäuse ein Gehäuseunterteil und ein Gehäuseoberteil umfassen. Der Keil kann verstellbar im Gehäuseunterteil gelagert sein. Das Gehäuseunterteil und das Gehäuseoberteil können mittels wenigstens einer Schraube miteinander verbunden sein.

In weiterer Ausgestaltung kann am Gehäuse ein elektrischer Anschluss für eine Zuleitung angeordnet sein. Der jeweilige Anschluss kann weiterhin mit der zugehörigen Stromschiene in elektrischer Verbindung stehen. Schließlich können die Vorbaugruppe und/oder die Steuerschaltung und/oder die Leiterplatte im Gehäuse befindlich sein.

Für eine besonders bevorzugte Ausgestaltung der Erfindung ist nachfolgendes festzustellen.

Zur Trennung einer Brennstoffzelle in einem Elektrofahrzeug werden aus Sicherheitsgründen jeweils ein Schütz in den BusBars FC HV + und FC HV - verwendet, um die Brennstoffzelle im Ruhezustand, beispielsweise Fahrzeug geparkt, Werkstattbesuch, nach einem Unfall o. dgl., allpolig vom Bordnetz sicher zu trennen. Dies ist notwendig, da die Spannung in der Brennstoffzelle durch Restwasserstoff und/oder Luftzufuhr über der Schutzkleinspannung liegen kann und damit gegebenenfalls eine tödliche Gefahr gegeben sein kann. Die Schutzkleinspannung beträgt im Allgemeinen weniger als 60 V, manche Elektrofahrzeughersteller fordern jedoch auch eine Hochvolt-Sicherheit von insbesondere weniger als 10 V.

Alternativ kann der sichere Zustand über einen Kurzschluss der Brennstoffzelle hergestellt werden. Diese Lösung ist erprobt und hat ihre Funktionstüchtigkeit bewiesen. Eine weitere Alternative hierzu ist die Verwendung eines galvanisch getrennten DC/DC-Wandlers, der die Brennstoffzelle ohne Betrieb auch abkoppelt.

Für den Kurzschluss werden Halbleiterschalter verwendet, die als sicheren Zustand einen Kurzschluss haben. Dies wird derzeit in der Bauform PUK und mittels Pressverbindung sichergestellt, da alle anderen Verfahren, wie Bonding, Sintern o. dgl., immer auch eine mögliche Trennstelle darstellen.

Die Aufbau- und Verbindungstechnik des als Halbleiterschalters ausgebildeten, erfindungsgemäßen Schaltelements umfasst
- die Kontaktierung des Halbleiterschalters und
- die Kontaktierung für den Steueranschluss des Halbleiterschalters.

Eine geschraubte Pressverbindung von Halbleiterschaltern ist bekannt und Stand der Technik, beispielsweise in HVÜ(Hochvolt-Übertragungs)-Anlagen, wo eine sehr hohe Anzahl von Thyristoren und/oder GTOs in Reihenschaltung verwendet werden. Defekte Bauteile können im Betrieb bleiben, da eine 100% sichere Funktion als Kurzschluss gegeben ist. Lediglich die Spannungsaufteilung über die anderen Bauteile ändert sich dann.

Da das erfindungsgemäße Schaltelement in den Brennstoffzellen-Stack aus Sicherheitsgründen integriert werden soll, damit kein Abriss im Falle eines Unfalls auftritt, ist eine Verwendung der Hochstromverbindung (BusBars) zur Kontaktierung und/oder Wärmeableitung möglich. Zudem kann bei einem abgedichteten Design auch eine Thyristorunterbaugruppe als Pellet verwendet werden, die deutlich günstiger als ein Thyristor mit einem PUK-Gehäuse ist. Sowohl die Zuverlässigkeit als auch die Montage können durch die Verwendung einer Keilmontage mit Federkraftaufbringung optimiert werden.

Geschaffen ist durch die Erfindung ein Schaltelement als Reversibler Automatic Discharger für die Verwendung in einem Brennstoffzellen-Stack.

Die mit der Erfindung erzielten Vorteile bestehen insbesondere darin, dass das Schaltelement zuverlässig betreibbar ist und damit in sicherheitskritischen Anwendungen, insbesondere in der Elektromobilität, einsetzbar ist. Des Weiteren ist das Schaltelement kostengünstig.

Ein Ausführungsbeispiel der Erfindung mit verschiedenen Weiterbildungen und Ausgestaltungen ist in den Zeichnungen dargestellt und wird im folgenden näher beschrieben. Es zeigen
Fig. 1 ein Schaltelement in Explosions-Darstellung,
Fig. 2 Einzelteile aus Fig. 1 in vergrößerter Darstellung und
Fig. 3 eine Schnittdarstellung des Schaltelements aus Fig. 1.

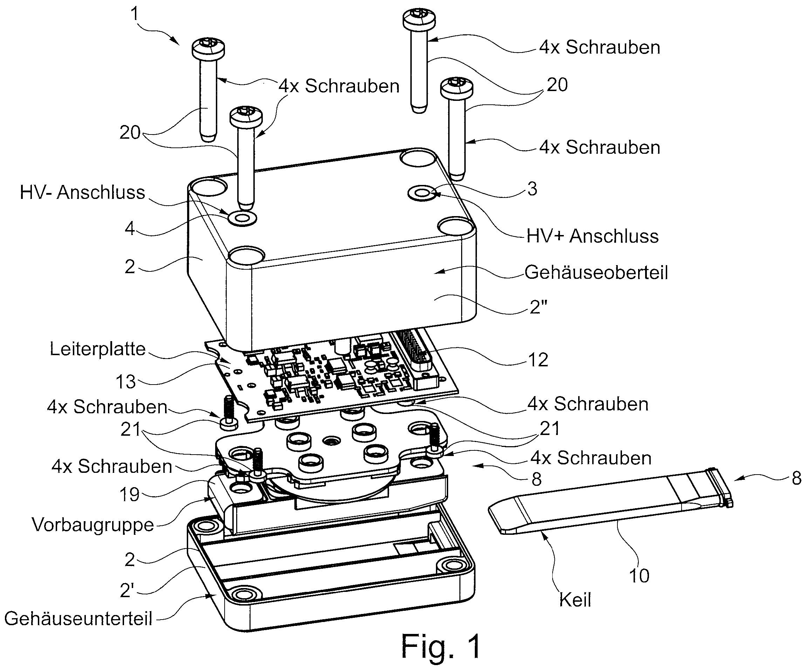

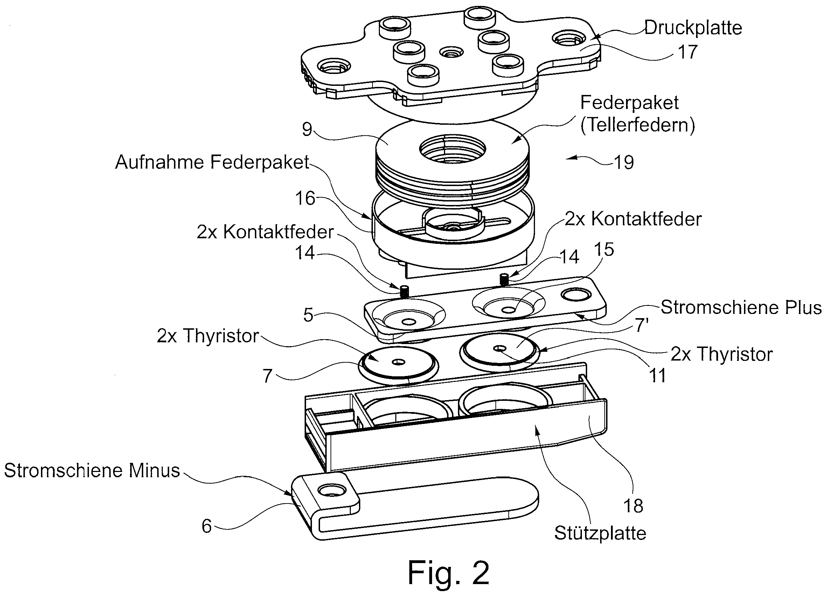

In Fig. 1 ist ein Schaltelement 1 zu sehen, das in einer ein Brennstoffzellen-Stack umfassenden Brennstoffzelle eines Elektrofahrzeugs verwendet wird und zur Herstellung einer Kurzschlussverbindung in der Brennstoffzelle dient. Das Schaltelement 1 besitzt ein Gehäuse 2, das ein Gehäuseunterteil 2' und ein Gehäuseoberteil 2" umfasst, wobei das Gehäuseunterteil 2' und das Gehäuseoberteil 2" mittels wenigstens einer Schraube 20 miteinander verbunden sind. Am Gehäuse 2 ist ein elektrischer Anschluss 3, 4 für eine Zuleitung zum jeweiligen Pol des Brennstoffzellen-Stacks angeordnet, und zwar der Anschluss 3 als Hochvolt-Anschluss HV+ zum Pluspol sowie der Anschluss 4 als Hochvolt-Anschluss HV- zum Minuspol des Brennstoffzellen-Stacks. Im Gehäuse 2 befinden sich zwei voneinander beabstandet angeordnete, in Fig. 2 sichtbare Stromschienen 5, 6, wobei der jeweilige Anschluss 3, 4 mit der zugehörigen Stromschiene 5, 6 in elektrischer Verbindung steht. Und zwar steht die Stromschiene 5 mit dem Anschluss 3 als Stromschiene Plus sowie die Stromschiene 6 mit dem Anschluss 4 als Stromschiene Minus in Verbindung.

Wie weiter anhand der Fig. 2 zu erkennen ist, ist zwischen den beiden Stromschienen 5, 6 wenigstens ein Leistungshalbleiter 7 angeordnet, wobei der Leistungshalbleiter 7 jeweils an den Stromschienen 5, 6 anliegt. Zwecks betriebs- und/oder funktionssicherer Anlage des Leistungshalbleiters 7 an den Stromschienen 5, 6 ist des Weiteren ein in Fig. 1 näher bezeichnetes Mittel 8 zur Anpressung des Leistungshalbleiters 7 an die Stromschienen 5, 6 vorgesehen. Der Leistungshalbleiter 7 ist zwischen einem elektrisch nichtleitenden und einem elektrisch leitenden Zustand umschaltbar, so dass im leitenden Zustand des Leistungshalbleiters 7 ein elektrischer Kurzschluss zwischen den beiden Stromschienen 5, 6 und damit für den Brennstoffzellen-Stack bewirkbar ist. Im nichtleitenden Zustand des Leistungshalbleiters 7 hingegen befindet sich der Brennstoffzellen-Stack im normalen Betrieb zur Erzeugung von elektrischer Energie für das Elektrofahrzeug.

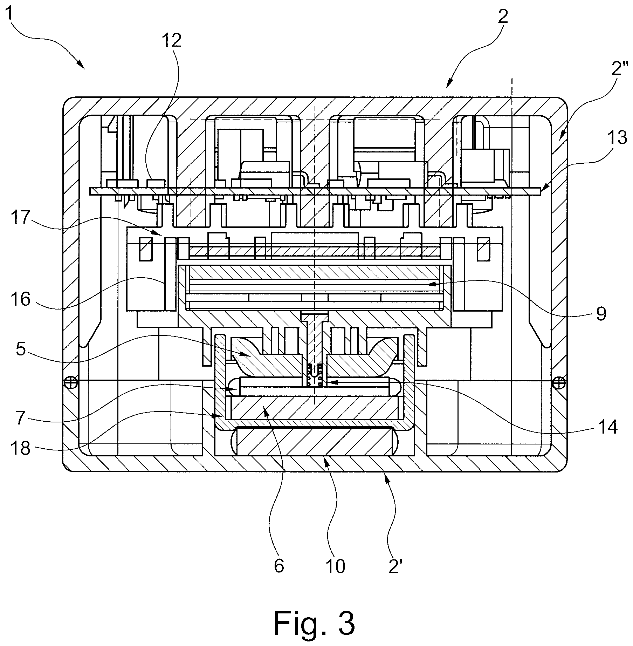

Die Ausgestaltung des Mittels 8 zur Anpressung des Leistungshalbleiters 7 an die Stromschienen 5, 6 ist näher in der Fig. 2 und der Fig. 3 zu sehen. Das Mittel 8 zur Anpressung des Leistungshalbleiters 7 an die Stromschienen 5, 6 umfasst eine auf die eine Stromschiene 5 einwirkende Feder 9. Zur Erzeugung einer genügend hohen, auf die Stromschiene 5 einwirkenden elastischen Kraft bietet es sich an, dass es sich bei der Feder 9 um ein Federpaket bestehend aus Tellerfedern handelt, wie der Fig. 2 entnommen werden kann. Des Weiteren umfasst das Mittel 8 zur Anpressung des Leistungshalbleiters 7 an die Stromschienen 5, 6 einen auf die andere Stromschiene 6 einwirkenden Keil 10. Der Keil 10 ist verstellbar im Gehäuseunterteil 2' gelagert, wie anhand der Fig. 1 zu sehen ist, so dass der Anpressdruck für den Leistungshalbleiter 7 durch entsprechende Verschiebung des Keils 10 einstellbar ist.

Um eine Überlastung auch bei hohen Strömen zu vermeiden, können zwei Leistungshalbleiter 7, 7' in elektrischer Parallelschaltung zwischen den Stromschienen 5, 6 angeordnet sein, wie in Fig. 2 zu sehen ist. Bei dem Leistungshalbleiter 7, 7' kann es sich um einen Leistungstransistor, beispielsweise um einen Thyristor, handeln. Der Leistungshalbleiter 7, 7' ist in Form eines scheibenförmigen, ungehäusten Pellets ausgebildet, wie der Fig. 2 zu entnehmen ist. Der Leistungshalbleiter 7, 7' weist einen Steueranschluss in der Art eines Gates zum Umschalten zwischen dem nichtleitenden und dem leitenden Zustand auf, wobei der Steueranschluss in einer Vertiefung 11 an der Oberfläche des Pellets befindlich ist. Des Weiteren ist eine Steuerschaltung 12 zur Ansteuerung des Leistungshalbleiters 7, 7', also insbesondere zur Umschaltung des Leistungshalbleiters 7, 7' zwischen dem nichtleitenden und dem leitenden Zustand, vorgesehen. Die Steuerschaltung 12 ist auf einer im Gehäuse 2 befindlichen Leiterplatte 13 angeordnet, wobei die Leiterplatte 13 gemäß Fig. 1 mittels Schrauben 21 im Gehäuseoberteil 2" befestigt ist. Schließlich ist noch eine Kontaktfeder 14 zur elektrischen Verbindung zwischen dem Steueranschluss des Leistungshalbleiters 7, 7' und der Steuerschaltung 12 vorgesehen. Hierfür ist die Kontaktfeder 14 einerseits in der Vertiefung 11 am Steueranschluss des Leistungshalbleiters 7, 7' gehalten, wobei die Kontaktfeder 14 durch eine Ausnehmung 15 in der Stromschiene 5 hindurchragt, sowie besitzt andererseits eine elektrische Verbindung zur Steuerschaltung 12. Beispielsweise kann die Kontaktfeder 14 andererseits an einer nicht weiter gezeigten, auf der Leiterplatte 13 befindlichen, eine elektrische Verbindung zur Steuerschaltung 12 herstellenden Kontaktfläche anliegen. Selbstverständlich kann die Kontaktfeder 14 auch in sonstiger Weise, beispielsweise über eine Zuleitung, mit der Steuerschaltung 12 in elektrischer Verbindung stehen.

Wie in Fig. 2 weiter zu sehen ist, ist eine Aufnahme 16 für die Feder 9 vorgesehen. Die Aufnahme 16 liegt gemäß Fig. 3 an der einen Stromschiene 5 an. Der Aufnahme 16 gegenüberliegend ist eine im Gehäuseoberteil 2" abgestützte Druckplatte 17 zur Abstützung der Feder 9 vorgesehen. Schließlich ist eine im Gehäuseunterteil 2' angeordnete, mittels des Keils 10 beaufschlagte Stützplatte 18 für die Halterung des Leistungshalbleiters 7, 7' sowie der beiden Stromschienen 5, 6 vorgesehen. Die Aufnahme 16, die Druckplatte 17 und die Stützplatte 18 mitsamt der Feder 9, dem Leistungshalbleiter 7, 7' sowie den Stromschienen 5, 6 sind vormontierbar, gemäß Fig. 1 in der Art einer Vorbaugruppe 19 ausgebildet. Die Vorbaugruppe 19 und die Leiterplatte 13 mit der Steuerschaltung 12 befinden sich nach Montage des Schaltelements 1 im Gehäuse 2.

Die Erfindung ist nicht auf das beschriebene und dargestellte Ausführungsbeispiel beschränkt. Sie umfasst vielmehr auch alle fachmännischen Weiterbildungen im Rahmen der durch die Patentansprüche definierten Erfindung. So kann das erfindungsgemäße Schaltelement 1 nicht nur in einer Brennstoffzelle für ein Elektrofahrzeug Verwendung finden, sondern kann auch in Brennstoffzellen-Stacks für die Energieerzeugung zum Betrieb sonstiger Elektrogeräte eingesetzt werden.

### Bezugszeichen-Liste:

- 1:: Schaltelement
- 2:: Gehäuse
- 2':: Gehäuseunterteil
- 2":: Gehäuseoberteil
- 3:: (elektrischer) Anschluss (HV+)
- 4:: (elektrischer) Anschluss (HV-)
- 5:: Stromschiene (Plus)
- 6:: Stromschiene (Minus)
- 7,7':: Leistungshalbleiter
- 8:: Mittel zur Anpressung (des Leistungshalbleiters)
- 9:: Feder
- 10:: Keil
- 11:: Vertiefung (in Leistungshalbleiter für den Steueranschluss)
- 12:: Steuerschaltung
- 13:: Leiterplatte
- 14:: Kontaktfeder (für Leistungshalbleiter)
- 15:: Ausnehmung (in Stromschiene)
- 16:: Aufnahme (für Feder)
- 17:: Druckplatte
- 18:: Stützplatte
- 19:: Vorbaugruppe
- 20:: Schraube (für Gehäuse)
- 21:: Schraube (für Leiterplatte)

## Patentansprüche

1. Schaltelement zur Herstellung einer Kurzschlussverbindung, mit zwei voneinander beabstandet angeordneten Stromschienen (5, 6) und wenigstens einem zwischen den beiden Stromschienen (5, 6) angeordneten sowie jeweils an den Stromschienen (5, 6) anliegenden Leistungshalbleiter (7),
wobei der Leistungshalbleiter (7) zwischen einem elektrisch nichtleitenden und einem elektrisch leitenden Zustand umschaltbar ist,
wobei ein Mittel (8) zur Anpressung des Leistungshalbleiters (7) an die Stromschienen (5, 6) vorgesehen ist und
wobei das Mittel (8) zur Anpressung des Leistungshalbleiters (7) an die Stromschienen (5, 6) eine auf die eine Stromschiene (5) einwirkende Feder (9) umfasst, **dadurch gekennzeichnet, dass**
das Mittel (8) zur Anpressung des Leistungshalbleiters (7) an die Stromschienen (5, 6) einen auf die andere Stromschiene (6) einwirkenden Keil (10) zur Einstellung einer Kontaktkraft umfasst.

2. Schaltelement nach Anspruch 1, **dadurch gekennzeichnet,**
**dass** die Feder (9) zur Anpressung des Leistungshalbleiters (7) an die Stromschienen (5, 6) ein auf die eine Stromschiene (5) einwirkendes Federpaket bestehend aus Tellerfedern ist.

3. Schaltelement nach Anspruch 1 oder 2, **dadurch gekennzeichnet,**
**dass** zwei Leistungshalbleiter (7, 7') parallel zwischen den Stromschienen (5, 6) angeordnet sind.

4. Schaltelement nach dem vorhergehenden Anspruch,
wobei der Leistungshalbleiter (7, 7') in Form eines scheibenförmigen, ungehäusten Pellets ausgebildet ist.

5. Schaltelement nach einem der vorhergehenden Ansprüche,
wobei der Leistungshalbleiter (7, 7') einen Steueranschluss in der Art eines Gates zum Umschalten zwischen dem elektrisch nichtleitenden und dem elektrisch leitenden Zustand aufweist.

6. Schaltelement nach dem vorhergehenden Anspruch,
wobei eine Steuerschaltung (12) zur Ansteuerung des Leistungshalbleiters (7, 7') vorgesehen ist.

7. Schaltelement nach dem vorhergehenden Anspruch,
wobei eine Kontaktfeder (14) zur elektrischen Verbindung zwischen dem Steueranschluss des Leistungshalbleiters (7, 7') und der Steuerschaltung (12) vorgesehen ist.

8. Schaltelement nach einem der Ansprüche 6 oder 7,
wobei die Steuerschaltung (12) auf einer Leiterplatte (13) befindlich ist
und wobeider Steueranschluss für den Leistungshalbleiter (7, 7') in einer Vertiefung (11) an der Oberfläche des Pellets befindlich ist.

9. Schaltelement nach dem vorhergehenden Anspruch,
wobei die Kontaktfeder (14) einerseits am Steueranschluss des Leistungshalbleiters (7, 7') und in der Vertiefung (11) gehalten ist sowie andererseits mit der Steuerschaltung (12) in elektrischer Verbindung steht.

10. Schaltelement nach einem der Ansprüche 1 bis9,
wobei eine Aufnahme (16) für die Feder (9) vorgesehen ist
und wobei die Aufnahme (16) an der einen Stromschiene (5) anliegt.

11. Schaltelement nach dem vorhergehenden Anspruch,
wobei der Aufnahme (16) gegenüberliegend eine Druckplatte (17) zur Abstützung der Feder (9) vorgesehen ist,
wobei eine Stützplatte (18) für die Halterung des Leistungshalbleiters (7, 7') vorgesehen ist.

12. Schaltelement nach dem vorhergehenden Anspruch,
wobei die Stützplatte (18) für die Halterung der beiden Stromschienen (5, 6) vorgesehen ist.

13. Schaltelement nach einem der Ansprüche 10 bis 12,
wobei die Aufnahme (16), die Druckplatte (17) und die Stützplatte (18) in der Art einer Vorbaugruppe (19) ausgebildet sind.

14. Schaltelement nach einem der Ansprüche 1 bis 13, **dadurch gekennzeichnet,**
**dass** ein Gehäuse (2) vorgesehen ist, dass das Gehäuse (2) ein Gehäuseunterteil (2') und ein Gehäuseoberteil (2") umfasst,
und **dass** der Keil (10) verstellbar im Gehäuseunterteil (2') gelagert ist.

15. Schaltelement nach einem der Ansprüche 1 bis 14, **dadurch gekennzeichnet,**
**dass** am Gehäuse (2) ein elektrischer Anschluss (3, 4) für eine Zuleitung angeordnet ist,
**dass** der jeweilige Anschluss (3, 4) mit der zugehörigen Stromschiene (5, 6) in elektrischer Verbindung steht,
und **dass** die Vorbaugruppe (19) und/oder die Steuerschaltung (12) und/oder die Leiterplatte (13) im Gehäuse (2) befindlich sind.

## Claims

1. A switching element for creating a short-circuit connection with two busbars (5, 6) arranged spaced apart from one another and at least one power semiconductor (7) arranged between the two busbars (5, 6) and respectively abutting the busbars (5, 6), wherein the power semiconductor (7) is switchable between an electrically non-conducting and an electrically conducting state,
wherein a means (8) for pressing the power semiconductor (7) to the busbars (5, 6) is provided and wherein the means (8) for pressing the power semiconductor (7) to the busbars (5, 6) comprises a spring (9) acting on the one busbar (5), **characterised in that** the means (8) for pressing the power semiconductor (7) to the busbars (5, 6) comprises a wedge (10) acting on the other busbar (6) for adjusting a contact force.

2. The switching element according to claim 1, **characterised in that**
the spring (9) for pressing the power semiconductor (7) to the busbars (5, 6) is a spring package consisting of disc springs acting on the one busbar (5).

3. The switching element according to claim 1 or 2, **characterised in that**
two power semiconductors (7, 7') are arranged in parallel between the busbars (5, 6).

4. The switching element according to the preceding claim,
wherein the power semiconductor (7, 7') is formed in the shape of a disc-shaped pellet without a housing.

5. The switching element according to any one of the preceding claim,
wherein the power semiconductor (7, 7') has a control port of the type of a gate for switching between the electrically non-conducting and the electrically conducting state.

6. The switching element according to the preceding claim,
wherein a control switch (12) for controlling the power semiconductor (7, 7') is provided.

7. The switching element according to the preceding claim,
wherein a contact spring (14) for electrical connection between the control port of the power semiconductor (7, 7') and the control switch (12) is provided.

8. The switching element according to any one of claims 6 or 7,
wherein the control switch (12) is located on a circuit board (13) and wherein the control port for the power semiconductor (7, 7') is located in a recess (11) on the surface of the pellet.

9. The switching element according to the preceding claim,
wherein the contact spring (14) is held on the control port of the power semiconductor (7, 7') and in the recess (11) on the one hand and is in electrical connection with the control switch (12) on the other hand.

10. The switching element according to any one of claims 1 to 9,
wherein a receptacle (16) for the spring (9) is provided and wherein the receptacle (16) abuts the one busbar (5).

11. The switching element according to the preceding claim,
wherein a pressure plate (17) for supporting the spring (9) is provided opposite the receptacle (16),
wherein a support plate (18) for holding the power semiconductor (7, 7') is provided.

12. The switching element according to the preceding claim,
wherein the support plate (18) is provided for holding the two busbars (5, 6).

13. The switching element according to any one of claims 10 to 12,
wherein the receptacle (16), the pressure plate (17) and the support plate (18) are formed in the type of a pre-assembly group (19).

14. The switching element according to any one of claims 1 to 13, **characterised in that**
a housing (2) is provided, the housing (2) comprises a housing lower part (2') and a housing upper part (2"),
and **in that** the edge (10) is adjustably mounted in the housing lower part (2').

15. The switching element according to any one of claims 1 to 14, **characterised in that**
an electrical port (3, 4) for a supply line is arranged on the housing (2),
the respective port (3, 4) is in electrical connection with the associated busbar (5, 6), and **in that** the pre-assembly group (19) and/or the control switch (12) and/or the circuit board (13) are located in the housing (2).

## Revendications

1. Elément de commutation pour réaliser une connexion en court-circuit, comprenant deux barres omnibus (5, 6) disposées à distance l'une de l'autre et au moins un semi-conducteur de puissance (7) disposé entre les deux barres omnibus (5, 6) et reposant sur les barres omnibus (5, 6),
le semi-conducteur de puissance (7) pouvant être commuté entre un état électriquement non conducteur et un état électriquement conducteur,
un moyen (8) pour presser le semi-conducteur de puissance (7) sur les barres omnibus (5, 6) étant prévu et le moyen (8) pour presser le semi-conducteur de puissance (7) sur les barres omnibus (5, 6) comprenant un ressort (9) agissant sur une barre omnibus (5), **caractérisé en ce que** le moyen (3) pour presser le semi-conducteur de puissance (7) sur les barres omnibus (5, 6) comprend une cale (10) agissant sur l'autre barre omnibus (6) pour régler une force de contact.

2. Elément de commutation selon la revendication 1, **caractérisé en ce que**
le ressort (9) pour presser le semi-conducteur de puissance (7) sur les barres omnibus (5, 6) est un ensemble ressort composé de ressorts à disques agissant sur une barre omnibus (5).

3. Elément de commutation selon la revendication 1 ou 2, **caractérisé en ce que**
deux semi-conducteurs de puissance (7, 7') sont disposés en parallèle entre les barres omnibus (5, 6).

4. Elément de commutation selon la revendication précédente,
dans lequel les semi-conducteurs de puissance (7, 7') sont réalisés sous la forme d'une pastille en forme de disque, non logée.

5. Elément de commutation selon l'une quelconque des revendications précédentes,
dans lequel les semi-conducteurs de puissance (7, 7') présentent une connexion de commande sous la forme d'une grille pour la commutation entre l'état électriquement non conducteur et l'état électriquement conducteur.

6. Elément de commutation selon la revendication précédente,
dans lequel un circuit de commande (12) est prévu pour commander les semi-conducteurs de puissance (7, 7').

7. Elément de commutation selon la revendication précédente,
dans lequel un ressort de contact (14) est prévu pour la liaison électrique entre la connexion de commande des semi-conducteurs de puissance (7, 7') et le circuit de commande (12).

8. Elément de commutation selon l'une des revendications 6 ou 7,
dans lequel le circuit de commande (12) est situé sur une carte de circuit imprimé (13) et
dans lequel la connexion de commande pour les semi-conducteurs de puissance (7, 7') est située dans un évidement (11) sur la surface de la pastille.

9. Elément de commutation selon la revendication précédente,
dans lequel le ressort de contact (14) est maintenu d'une part sur la connexion de commande des semi-conducteurs de puissance (7, 7') et dans l'évidement (11) et d'autre part est en liaison électrique avec le circuit de commande (12).

10. Elément de commutation selon l'une des revendications 1 à 9,
dans lequel un logement (16) est prévu pour le ressort (9) et dans lequel le logement (16) repose sur une barre omnibus (5).

11. Elément de commutation selon la revendication précédente,
dans lequel une plaque de pression (17) est prévue en face du logement (16) pour supporter le ressort (9),
dans lequel une plaque de support (18) est prévue pour supporter les semi-conducteurs de puissance (7, 7').

12. Elément de commutation selon la revendication précédente,
dans lequel la plaque de support (18) est prévue pour supporter les deux barres omnibus (5, 6).

13. Elément de commutation selon l'une des revendications 10 à 12,
dans lequel le logement (16), la plaque de pression (17) et la plaque de support (18) sont conçus à la manière d'un pré-assemblage (19).

14. Elément de commutation selon l'une des revendications 1 à 13, **caractérisé en ce**
**qu'**un boîtier (2) est prévu, que le boîtier (2) comprend une partie inférieure de boîtier (2') et une partie supérieure de boîtier (2"), et
**que** la cale (10) est montée de manière réglable dans la partie inférieure de boîtier (2').

15. Elément de commutation selon l'une des revendications 1 à 14, **caractérisé en ce**
**qu'**une connexion électrique (3, 4) pour une ligne d'alimentation est disposée sur le boîtier (2),
**que** la connexion (3, 4) respective est en liaison électrique avec la barre omnibus (5, 6) associée, et
**que** le pré-assemblage (19) et/ou le circuit de commande (12) et/ou la carte de circuit imprimé (13) se trouvent dans le boîtier (2).
